Europäisches Patentamt

European Patent Office

Office européen des brevets

(11) Veröffentlichungsnummer: **0 355 736**
**A2**

## EUROPÄISCHE PATENTANMELDUNG

(21) Anmeldenummer: 89115261.3

(22) Anmeldetag: 18.08.89

(51) Int. Cl.⁴: **C23C 14/08** , **C23C 14/34** , **H01L 39/24**

(30) Priorität: 26.08.88 DE 3828925
25.11.88 DE 3839745

(43) Veröffentlichungstag der Anmeldung:
28.02.90 Patentblatt 90/09

(84) Benannte Vertragsstaaten:
CH DE FR GB LI

(71) Anmelder: HOECHST AKTIENGESELLSCHAFT
Postfach 80 03 20
D-6230 Frankfurt am Main 80(DE)

(72) Erfinder: Morach, Eugen
Höhenweg 6
D-6237 Liederbach(DE)
Erfinder: Peuckert, Marcellus, Dr.
Platanenweg 8
D-6238 Hofheim am Taunus(DE)
Erfinder: Schmidt, Günter, Dr.
Germanenweg 13
D-6272 Niedernhausen(DE)
Erfinder: Schölch, Hans-Peter, Dr.
Leipziger Strasse 30
D-6108 Weiterstadt(DE)

(54) Verfahren zur Herstellung eines anorganischen Dünnfilms auf einem Träger unter Verwendung eines Targets.

(57) Ein anorganischer Dünnfilm wird auf einem Träger dadurch aufgebracht, daß man ein Sputtertarget durch Kathodenzerstäubung in der Nähe des Trägers zerstäubt. Zur Herstellung des Targets werden mindestens zwei pulverförmiger Ausgangskomponenten vermischt. Das Gemisch wird getempert, falls hierbei ein einheitliches Reaktionsprodukt erhältlich ist. Dieses wird gepulvert und das Pulver durch Plasma-Spritzen auf eine metallische Unterlage aufgebracht. Dabei entsteht das Target. Vorzugsweise wird ein Oxidgemisch getempert, das ein Ausgangsprodukt für ein supraleitendes keramisches Material darstellt. Um den aufgetragenen Dünnfilm in einen supraleitenden Zustand zu überführen, wird er in einer Sauerstoff enthaltenden Atmosphäre längere Zeit bei Temperaturen von 300-800 °C behandelt. Das beim Tempern erhaltene Reaktionsprodukt kann z.B. die Bruttozusammensetzung $ZBa_mCu_nO_x$ mit $1,5 \leq m \leq 2,5$, $2 \leq n \leq 5$ und $4 \leq x \leq 9$ aufweisen, wobei Z für mindestens eines der Elemente Y, La, Nd, Sm, Eu, Gd, Dy, Ho, Er, Tm, Yb und Lu steht, oder die Bruttozusammensetzungen $TlBa_lCa_mCu_nO_x$ oder $BiSr_lCa_mCu_nO_x$ mit $0,3 \leq l \leq 3$, $0,3 \leq m \leq 3$, $0,3 \leq n \leq 3$ und $2 \leq x \leq 11$ aufweisen.

# Verfahren zur Herstellung eines anorganischen Dünnfilms auf einem Träger unter Verwendung eines Targets

Die vorliegende Erfindung betrifft ein Verfahren zur Herstellung eines dünnen anorganischen Films auf einem elektrisch leitenden oder elektrisch isolierenden Träger, wobei man ein Sputtertarget durch Kathodenzerstäubung in der Nähe des Trägers zerstäubt. Die Erfindung betrifft ferner ein Verfahren zur Herstellung des verwendeten Sputtertargets durch thermische Spritzprozesse.

Das Aufbringen von dünnen Schichten im Sputterverfahren auf Träger (= Substrate) aus Metall, Kunststoff oder Keramik für Anwendungen in den Bereichen Mikroelektronik, Datenspeicherung, Optik und Mechanik (Verminderung von Reibung und Verschleiß) ist von großer technischer Bedeutung. Dabei werden zunehmend Schichten interessant, die aus zwei, drei und mehr Komponenten zusammengesetzt sind. So handelt es sich beispielsweise bei den bisher bekannten neuen hochtemperatur-supraleitenden Materialien, bei denen die erste Anwendung voraussichtlich auch in Form dünner Filme erfolgen wird, um mindestens ternäre bis quaternäre Verbindungen. Um solche mehrkomponentigen Systeme im Sputterverfahren abzuscheiden, ist die Bereitstellung der entsprechenden Sputtertargets notwendig (L.I. Maissel, R. Glang, Handbook of Thin Film Technology).

Die Vielseitigkeit der Sputtertechnik im Bezug auf die zerstäubbaren Materialien erfordert ein großes Spektrum an verschiedenen Target-Werkstoffen. Darunter fallen Metalle und metallische Legierungen, halbleitende und keramische Stoffe im weitesten Sinne sowie Mischtargets aus metallischem und keramischem Material. Eine Reihe von Materialien werden im Vakuum erschmolzen, wobei die erforderliche Wärme i. a. durch induktive Heizung, gelegentlich aber auch durch Elektronenstrahl oder Lichtbogen zugeführt wird. Viele Metallkombinationen lassen sich jedoch nicht ohne weiteres legieren, da sie zumindestens bei Raumtemperatur Mischungslücken aufweisen. Auch ein sehr hoher Schmelzpunkt des Materials, stark unterschiedliche Dampfdrücke der Komponenten oder die Neigung zur Sublimation erschweren die schmelztechnische Targetherstellung. In diesen Fällen, insbesondere auch bei keramischen Materialien, wählt man die Methoden der Pulvermetallurgie. Dabei werden die gemischten pulverförmigen Ausgangsstoffe durch Heißpressen, isostatisches Pressen oder Kaltverdichten und anschließendes Sintern unter Druck verdichtet.

Diese Verfahren weisen insbesondere bei mehrkomponentigen Systemen erhebliche Nachteile auf. Auf pulvermetallurgischem Weg hergestellte Targets sind häufig sehr spröde und von unzureichender mechanischer Festigkeit, was bei der weiteren Verarbeitung zu Schwierigkeiten führt. Weiterhin sind auf diese Weise Targets nur in relativ kleinen Abmessungen und spezieller Form herstellbar. Schwierigkeiten bereiten außerdem die homogene Verteilung der Komponenten sowie die Gewährleistung gleichmäßiger Targeteigenschaften über die gesamte Fläche und Tiefe. Da die pulvermetallurgische Targetherstellung zudem ein teures Verfahren ist, kommen auf den Anwender, insbesondere wenn zahlreiche unterschiedliche Zusammensetzungen erprobt werden sollen, erhebliche Kosten zu. Weitere Kosten und Probleme, z. B. durch Interdiffusion, entstehen beim notwendigen Bonden dieser Materialien auf elektrisch leitende metallische Unterlagen oder Target-Halteplatten, die typischerweise aus Kupfer bestehen.

Es bestand daher die Aufgabe, ein Verfahren anzugeben, mit dem sich ein Sputtertarget aus mehreren Komponenten herstellen ließ, das sich zur Herstellung von Dünnfilmen durch Kathodenzerstäubung eignet, und dabei die den Methoden der Pulvermetallurgie anhaftenden Nachteile zu vermeiden.

Die Erfindung beruht auf der Erkenntnis, daß sich durch thermisches Spritzen von homogenisierten Pulvermischungen oder homogenen Pulvern auf metallischen, plattenförmigen Unterlagen (z. B. aus Kupfer, Eisen oder Stahl) Beschichtungen in einer Dicke von etwa 0,1 bis 3 mm herstellen lassen und daß diese sich ihrerseits im Verbund mit der Unterlage hervorragend als Target für Sputterprozesse wie z. B. DC-, RF-, Dioden-, Magnetron-oder auch reaktives Sputtern mit zusätzlichen gasförmigen Komponenten eignen.

Es wurde nun ein Verfahren zur Herstellung eines anorganischen Dünnfilms auf einem Träger durch Kathodenzerstäubung eines Sputtertargets in der Nähe des Trägers gefunden. Dieses Verfahren ist dadurch gekennzeichnet, daß man zur Herstellung des Targets mindestens zwei pulverförmige anorganische Ausgangskomponenten vermischt, das pulverförmige Gemisch gegebenenfalls tempert und erneut pulvert und das Pulver durch thermisches Spritzen auf einer elektrisch leitfähigen Unterlage aufbringt. Das Verfahren der Kathodenzerstäubung ist dem Fachmann bekannt, z. B. aus L.I. Maissel, R. Glang, Handbook of Thin Film Technology. Der Abstand des Targets vom Träger liegt bei Sputtern meist zwischen 1 cm und 10 cm.

Der Dünnfilm selbst kann auf einen elektrisch leitenden oder auch isolierenden Träger aufgetragen werden. Die Dicke der aufgesputterten Dünnschicht liegt i. a. zwischen 0,05 und 10 $\mu$m. Als

Substrate für die Dünnfilmherstellung eignen sich Einkristalle oder polykristalline Materialien in flächiger, fadenförmiger oder bänderartiger Geometrie. Die Substrate können z. B. aus Metallen, Silizium oder keramischen Materialien wie MgO, $SrTiO_3$, $Al_2O_3$, $LiNbO_3$ oder $ZrO_2$ bestehen.

Vor dem thermischen Spritzen wird das Gemisch der pulverförmigen anorganischen Ausgangskomponenten vorzugsweise getempert (d. h. längere Zeit erhitzt), falls es hierbei zu einer Feststoffreaktion kommt und dabei ein einheitliches oder nahezu einheitliches Reaktionsprodukt erhältlich ist. Ist das nicht der Fall, z. B. bei einem Gemisch von zwei hochschmelzenden Metallen, oder ist die Reaktion erst beim Sintern zu erzwingen, so wird auf das Tempern verzichtet.

Als thermische Spritzverfahren kommen vorwiegend das Flamm-und Plasmaspritzen mit den in DIN 32 530 (Entwurf Oktober 1987) aufgeführten Varianten zum Einsatz. Beim Flammspritzen wird allgemein der pulverförmige Spritzzusatz (= Beschichtungswerkstoff) in einer Brenngas-Sauerstoffflamme an- oder aufgeschmolzen und durch das expandierende Verbrennungsgas allein oder mit gleichzeitiger Unterstützung durch ein Zerstäubergas (z. B. Druckluft o. ä.) auf die Werkstoffoberfläche geschleudert. Beim Plasmaspritzen wird der pulverförmige Spritzzusatz inner- oder außerhalb der Spritzpistole durch eine Plasmaflamme aus der festen in die flüssige Phase übergeführt, beschleunigt und auf die Werkstoffoberfläche geschleudert.

In einem elektrischen Lichtbogen hoher Energiedichte, der zwischen einer Wolfram-Kathode und einer Kupfer-Anode brennt, werden die Gase (z. B. Argon, Helium, Wasserstoff, Stickstoff oder deren Gemische) in den Plasmazustand übergeführt. Ein elektrisch neutraler Plasmastrahl verläßt die als Brennerdüse ausgebildete Anode mit hoher Temperatur und Geschwindigkeit.

Geeignete Spritzzusätze sind sowohl Pulver und Pulvergemische als auch durch chemische Reaktion vorreagierte Pulver. Die Verwendung agglomerierter oder mit einem Binder oder einem Legierungsbestandteil umhüllter Pulver ist ebenfalls möglich.

Die Korngröße des pulverförmigen Spritzzusatzes beträgt vorteilhafterweise 1 bis 250 μm, bevorzugt 1 bis 90 μm, insbesondere 5 bis 45 μm. Maßgebend für die Wahl der Korngröße ist unter anderem die geforderte Rauheit der Spritzschicht, welche ohne Nachbearbeitung ca. 70 μm beträgt. Durch Nachbearbeitung, z. B. Schleifen, kann die Rauheit auf unter 1 μm gesenkt werden.

Als Target-Unterlage eignen sich alle Materialien mit guter elektrischer und thermischer Leitfähigkeit, z. B. Metalle oder Kohle. Vorzugsweise werden Kupferplatten mit einer Dicke von 1 bis 3 mm verwendet. Zur Verbesserung der Haftung und gleichzeitiger Verhinderung der Sinterdiffusion kann zwischen Unterlage und der später zu zerstäubenden Schicht eine Zwischenschicht aus einem metallischen oder keramischen Material aufgebracht werden. Die Dicke der aufgespritzten und später zu zerstäubenden Schicht beträgt 0,1 bis 3 mm.

Es ist ein wesentlicher Vorteil dieses Verfahrens, daß sich die Targets sehr einfach und kostengünstig herstellen lassen. Es können Targets beliebiger Größe und Form hergestellt werden, die auch für großflächige Beschichtungen sowie zum Besputtern faden- oder bandförmiger Substrate eingesetzt werden können. Beispielsweise kann man ein flächenförmiges Target herstellen, das in mindestens einer Längenausdehnung eine Abmessung von mindestens 20 cm erreicht. Dies ist mit den nach dem Stand der Technik üblichen pulvermetallurgischen Verfahren nicht möglich. Die Zahl der Komponenten ist frei wählbar und nach oben nicht begrenzt. Das Verfahren arbeitet auch mit einer einzigen reinen Komponente. Jedoch ist dann ein Heißpressen des Pulvers wirtschaftlicher. Durch den thermischen Spritzprozeß lassen sich auch homogen gemischte Schichten von Komponentenkombinationen erzeugen, die keine einheitlichen chemischen Verbindungen darstellen oder keine homogene, thermodynamisch stabile Mischungen oder Lösungen sind. Es können nach dem beschriebenen Verfahren Targets hergestellt werden, die aus einer plattenförmigen Unterlage mit Beschichtungen aus Metallen, Oxiden, Boriden, Fluoriden, Nitriden, Carbiden, Siliziden, Phosphiden, Chalkogeniden und anderen Stoffgruppen bestehen.

Die Komponenten der Spritzbeschichtung sind homogen verteilt und die Targeteigenschaften über die gesamte Fläche und Tiefe konstant. Weiterhin entfällt bei Targets, die durch thermisches Spritzen hergestellt wurden, der Bondvorgang, da diese Targets direkt auf die Kathode aufgeschraubt werden können.

Thermisch gespritzte Schichten weisen gegenüber Werkstoffen, die auf keramischem Wege hergestellt wurden, charakteristische morphologische Besonderheiten auf. So erfolgt die Verbindung der auftreffenden Spritzteilchen mit dem Substratträger vorwiegend durch Adhäsion, mechanische Verankerung, Schrumpfkräfte und teilweise Verschweißung. Die während der Flugphase zum Teil oxidierten Spritzteilchen werden beim Aufprall verformt und passen sich der Rauheit der Werkstoffoberfläche an. Nachfolgende Teilchen bauen sich fladenförmig zu einer mikroporösen Schicht mit dazwischen liegenden Oxidschichten und Oxideinschlüssen auf. Im Gegensatz zu pulvermetallurgisch hergestellten Sputtertargets entsteht beim thermischen Spritzen eine für keramische Spritzschichten typische lamellare Schichtstruktur. Thermisches Spritzen in kontrollierter Gasatmosphäre von Ar, $H_2$, $N_2$, $CH_4$, $SiH_4$, $O_2$, $F_2$ etc. führt zu metallischen, nitridischen, carbidischen, silizidischen, oxidischen, fluoridischen etc. Sputtertargets.

Thermisch gespritzte Targets sind für den Einsatz in Dioden und Magnetronsputteranlagen geeignet. Sie können sowohl im HF-(Hochfrequenz) als auch bei ausreichender elektrischer Leitfähigkeit der aufgespritzten Schicht im DC-(Gleichstrom) Sputterverfahren eingesetzt werden. Es ist unter Verwendung thermisch gespritzter Targets speziell möglich, supraleitende Dünnschichten herzustellen.

Insbesondere können nach dem erfindungsgemäßen Verfahren auch Sputtertargets hergestellt werden, die in ihrer Zusammensetzung einem supraleitenden keramischen Material entsprechen oder nahekommen. In diesem Fall kann man zunächst in an sich bekannter Weise aus entsprechenden pulverförmigen Oxiden oder Oxidvorläufern durch eine Feststoffreaktion ein meist pulverförmiges Produkt erhalten, das gegebenenfalls bis auf den Sauerstoffgehalt in der Zusammensetzung einem Supraleiter entspricht oder ihm nahekommt. Beispielsweise kann ein Gemisch aus $Bi_2O_3$, SrO, CaO und $Cu_2O$ die Bruttozusammensetzung $Bi_2Sr_2Ca_2Cu_3O_{8,5}$ aufweisen, während der entsprechende oxidkeramische Supraleiter die Formel $Bi_2Sr_2Ca_2Cu_3O_{10-x}$ mit höherem Sauerstoffgehalt besitzt. Das Produkt der Feststoffreaktion wird gepulvert und dann durch thermisches Spritzen auf einen elektrisch leitfähigen Träger aufgebracht. Bei der nachfolgenden Kathodenzerstäubung des so entstandenen Targets (= Sputtern) kann die unterschiedliche Flüchtigkeit der einzelnen Atomsorten zu einer geringen Verschiebung der Stöchiometrie führen. Daher ist es möglich und auch vorteilhaft, im verwendeten Target den Anteil an leichtflüchtigen Komponenten, z. B. an Erdalkalien, etwas gegenüber der beabsichtigten Zusammensetzung zu erhöhen. Die erforderliche Erhöhung läßt sich durch Vorversuche ermitteln.

Insbesondere lassen sich mit dem angegebenen Verfahren durch thermisches Spritzen Targets und durch Sputtern von diesen Targets Dünnfilme der Bruttozusammensetzung $ZBa_mCu_nO_x$ gewinnen, wobei Z für mindestens eines der Element Y, La, Nd, Sm, Eu, Gd, Dy, Ho, Er, Tm, Yb oder Lu steht und wobei m eine Zahl zwischen 1,5 und 2,5, n eine Zahl zwischen 2 und 5 und x eine Zahl zwischen 4 und 9 ist. Die Herstellung von Schichten der ungefähren Zusammensetzung $YBa_2Cu_3O_x$ durch Plasmaspritzen wurde beschrieben von R.A. Neiser et al. (Materials Science and Engineering 91 (1987), L13). Die so hergestellten Schichten wurden jedoch nicht als Targets verwendet.

Ebenso lassen sich nach diesem Verfahren Targets (und Überzüge) der Bruttozusammensetzung $BiSr_lCa_mCu_nO_x$ herstellen, wobei l, m und n Zahlen zwischen 0,3 und 3 und x eine Zahl zwischen 2 und 11 ist.

Die durch Sputtern aufgetragenen Dünnfilme können in an sich bekannter Weise in ein supraleitendes keramisches Material überführt werden, indem man den Sauerstoffgehalt - symbolisiert durch (x) - erhöht. Dies geschieht durch längeres Tempern des Dünnfilms im Bereich von 300 bis 800 °C in einer Sauerstoff enthaltenden Atmosphäre. Dieses Tempern soll mindestens 10 min, vorzugsweise mindestens 1 h dauern. Längeres Tempern ist unschädlich.

Die Erfindung wird durch die Beispiele näher erläutert.

Beispiel 1

Mittels Plasmaspritzen wird ein durch Feststoffreaktion erzeugtes supraleitendes Pulver der Zusammensetzung $Bi_2Sr_1Ca_1Cu_1O_x$ auf eine Kupferunterlage von 3 mm Dicke und einem Durchmesser von 75 mm in einer Dicke von 0,5 mm aufgebracht. Die Stöchiometrie der aufgespritzten Schicht ist laut einer EDX-Analyse $Bi_2Sr_{0,7}Ca_{0,8}Cu_{1,0}O_x$. Dieses Target ist im so hergestellten Zustand elektrisch isolierend (R > 30 MΩ, 1 cm Meßspitzenabstand und für den Einsatz im RF-Sputterverfahren geeignet. Durch eine entsprechende thermische Nachbehandlung (10 Minuten bei 800 °C in fließendem Sauerstoff, danach Ofenabkühlung in 1 Stunde auf 400 - 500 °C, anschließend Abschrecken an Luft auf Raumtemperatur) wird die Beschichtung des Targets leitfähig (R ≈ 200 Ω - 1000 Ω) und dieses damit als DC-Sputterkathode verwendbar.

Mit diesem Target wurden in einer Magnetron-Sputteranlage Z 400 (Leybold AG) im RF-Modus bei 13,56 MHz ein Film auf $SrTiO_3$ (100)-Einkristalloberflächen aufgebracht. Dazu wurde die Anlage zunächst auf einen Basisdruck kleiner 5 • $10^{-4}$ Pa evakuiert. Der Sputterprozeß selbst erfolgte in reinem Argon bei einem Druck von 0,8 Pa und einem Target-Substrat Abstand von 30 mm. Die Substrate befinden sich auf Raumtemperatur. Bei einer Leistung von 250 W (U = 2,6 kV, J = 0,1 A) stellt sich eine Targetgleichspannung von 100 V ein. Die Abscheiderate beträgt im RF-Modus etwa $10^{-8}$ cm/s.

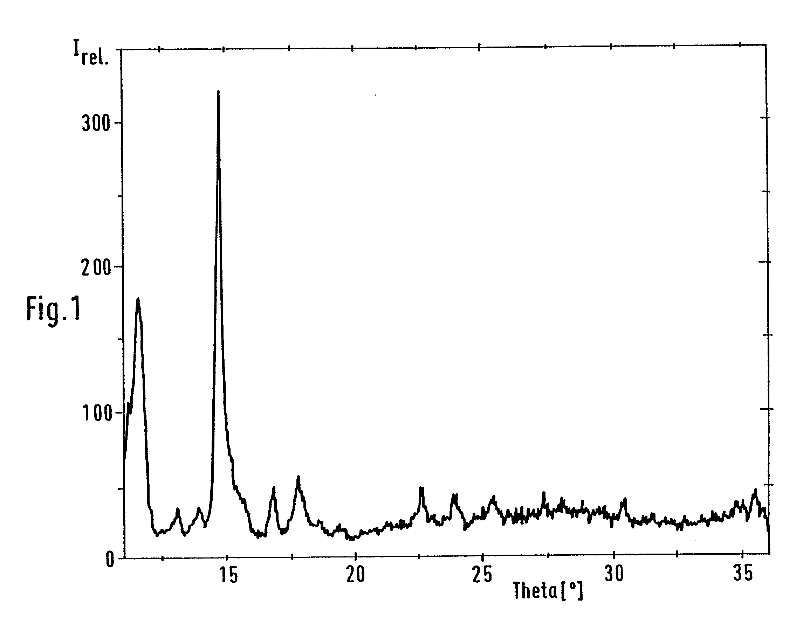

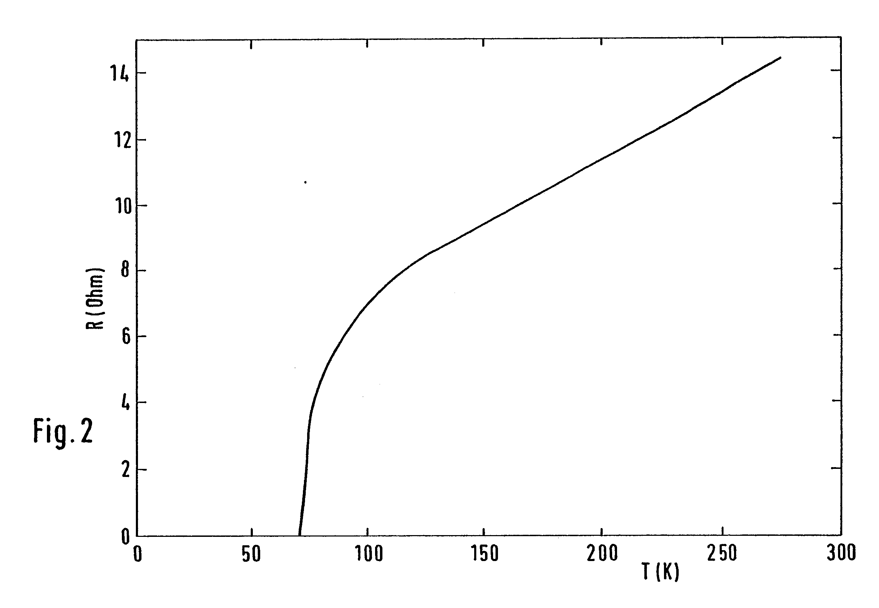

Ungetemperte Filme sind elektrisch isolierend und zeigen ein amorphes Röntgenspektrum. Nach einer thermischen Nachbehandlung (7 Min. bei 820 °C in $O_2$ und anschließendes Abschrecken an Luft) sind die Filme kristallin und supraleitend mit kritischen Onsettemperaturen von 96 K. Ein Röntgendiffraktiogramm ist in Fig. 1 abgebildet. Die Abhängigkeit des Widerstands R von der Temperatur geht aus Fig. 2 hervor.

## Beispiel 2

Analog Beispiel 1 wird ein supraleitendes Pulver der Zusammensetzung $YBa_2Cu_3O_x$ auf eine Kupferunterlage in einer Dicke von 0,5 mm aufgespritzt. Die Schicht weist gegenüber dem Ausgangspulver einen Cu-Unterschuß von 15 % auf. Nach einer thermischen Nachbehandlung (20 Minuten bei 950°C in fließendem $O_2$ und langsamen Abkühlen auf Raumtemperatur) ist die Beschichtung des Targets elektrisch leitend und diese kann als DC-Sputterkathode eingesetzt werden.

Mit diesem Target wurden in einer Magnetronsputteranlage im DC-Modus stöchiometrische $YBa_2Cu_3O_x$-Filme auf $SrTiO_3$ (100)-Einkristalloberflächen bei einer Substrattemperatur von 77 K und 373 K hergestellt. Der Sputterprozeß erfolgte in reinem Argon bei einem Druck von 1 Pa und einem Target-Substrat Abstand von 30 mm. Bei einer Spannung von 200 V und einem Strom von 100 mA ergibt sich eine Abscheiderate von $10^{-8}$ cm/s.

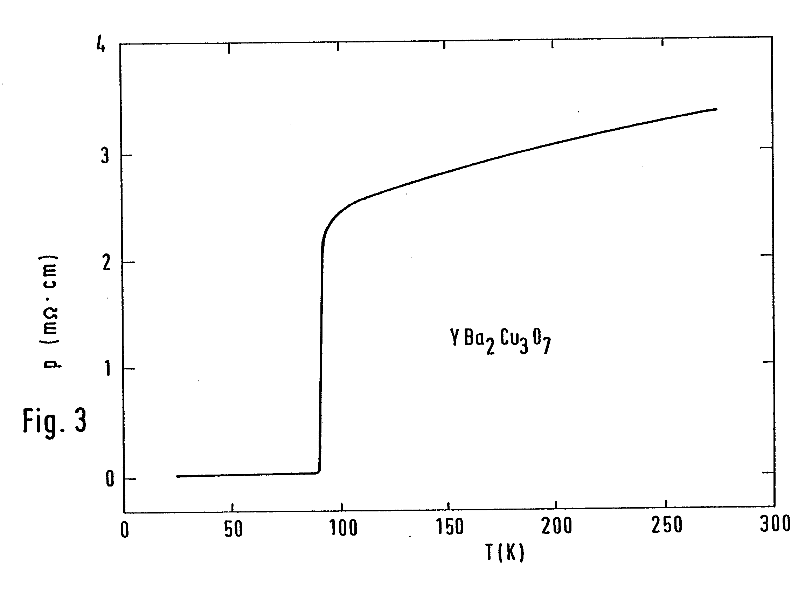

Im Anschluß an eine thermische Nachbehandlung (5 Minuten bei 920°C in fließendem $O_2$, 12 Stunden bei 450°C und anschließendes Abkühlen auf Raumtemperatur) zeigen die Filme oberhalb $T_c$ metallisches Widerstandsverhalten und eine Sprungtemperatur $T_c$ von 92 K mit einer Breite $\Delta T_c$ von 2 K. Die Abhängigkeit des spez. Widerstands $\rho$ von der Temperatur T geht aus Fig. 3 hervor.

## Ansprüche

1. Verfahren zur Herstellung eines Dünnfilms auf einem Träger, wobei man ein Sputtertarget durch Kathodenzerstäubung in der Nähe des Trägers zerstäubt, dadurch gekennzeichnet, daß man zur Herstellung des Targets mindestens zwei pulverförmige Ausgangskomponenten vermischt und das Pulver durch thermisches Spritzen auf eine elektrisch leitfähige Unterlage aufbringt.

2. Verfahren nach Anspruch 1, dadurch gekennzeichnet, daß man ein Gemisch von Oxiden oder Oxidvorläufern einsetzt und tempert, das ein Ausgangsprodukt für ein supraleitendes keramisches Material darstellt und man das beim Tempern erhaltene Reaktionsprodukt erneut pulvert und durch thermisches Spritzen auf eine leitfähige Unterlage aufbringt.

3. Verfahren nach Anspruch 1 oder 2, dadurch gekennzeichnet, daß man den durch Kathodenzerstäubung aufgetragenen Dünnfilm in einer Sauerstoff enthaltenden Atmosphäre längere Zeit bei Temperaturen von 300 bis 800°C behandelt.

4. Verfahren nach Anspruch 2, dadurch gekennzeichnet, daß das Reaktionsprodukt die Bruttozusammensetzung $ZBa_mCu_nO_x$ mit $1,5 \leq m \leq 2,5$, $2 \leq n \leq 5$ und $4 \leq x \leq 9$ aufweist, wobei Z für mindestens eines der Elemente Y, La, Nd, Sm, Eu, Gd, Dy, Ho, Er, Tm, Yb und Lu steht.

5. Verfahren nach Anspruch 2, dadurch gekennzeichnet, daß das Reaktionsprodukt die Bruttozusammensetzung $BiSr_lCa_mCu_nO_x$ mit $0,3 \leq 1 \leq 3$, $0,3 \leq m \leq 3$, $0,3 \leq n \leq 3$ und $2 \leq x \leq 11$ aufweist.

6. Verfahren nach Anspruch 2, dadurch gekennzeichnet, daß das Reaktionsprodukt die Bruttozusammensetzung $TlBa_lCa_mCu_nO_x$ mit $0,3 \leq 1 \leq 3$, $0,3 \leq m \leq 3$, $0,3 \leq n \leq 3$ und $2 \leq x \leq 11$ aufweist.

7. Verfahren nach Anspruch 2, dadurch gekennzeichnet, daß die leitfähige Unterlage aus Kupfer besteht.

8. Verfahren nach Anspruch 1, dadurch gekennzeichnet, daß man die Oberflächenrauhigkeit des verwendeten Sputtertargets durch Polieren auf Werte unter 1 $\mu$m verringert.

9. Verfahren gemäß Anspruch 1, dadurch gekennzeichnet, daß man das Gemisch der Ausgangsprodukte zur Durchführung einer Festkörperreaktion erhitzt, man das erhaltene einheitliche Reaktionsprodukt erneut pulvert und dann durch thermisches Spritzen aufbringt.

10. Verwendung eines Targets, bestehend aus einer homogenen Schicht eines Materials mit lamellarer Schichtstruktur, die auf einer Platte eines leitfähigen Metalls aufgebracht ist, zur Herstellung dünner Schichten nach dem Sputterverfahren.

11. Verwendung eines Targets gemäß Anspruch 10, dadurch gekennzeichnet, daß die homogene Schicht mit lamellarer Struktur des Targets eine Dicke von 0,1 bis 3 mm aufweist und in mindestens einer Längsausdehnung eine Abmessung von mindestens 20 cm erreicht.

Fig.1

EP 0 355 736 A2

Fig. 2

Fig. 3